# EUROPEAN PATENT APPLICATION

(11) **EP 4 503 117 A1**
(43) Date of publication of application: **05.02.2025**
(21) Application number: 23189005.4
(22) Date of filing: 01.08.2023
(51) Int. Cl.: H01L 23/14, H01L 23/373, B22F 10/28, H01L 23/00, H01L 23/495

(54) **A METHOD FOR FABRICATING A SINTERABLE METAL LAYER**

(71) Applicant: Infineon Technologies AG, 85579 Neubiberg (DE)
(72) Inventor: HAUPT, Marco, 44269 Dortmund (DE); OTTO, Frederik, 59399 Olfen (DE)
(74) Representative: Lambsdorff & Lange Patentanwälte Partnerschaft mbB

(57) **Abstract**

A method for fabricating a sinterable metal layer, the method comprising providing a substrate, applying a metal powder layer onto the substrate, melting and re-solidifying a predetermined area of the metal powder layer by scanning a laser beam or an electron beam over the predetermined area, and removing the remaining area of the metallic powder layer outside the predetermined area.

## Description

### TECHNICAL FIELD

The present disclosure is related to a method for fabricating a sinterable metal layer, a method for fabricating an electrical device, and an electrical device.

### BACKGROUND

Electronic devices, for example power electronic devices, may comprise a semiconductor die or semiconductor chip which is attached to a chip pad of a substrate, for example a DCB (direct copper bond) or an AMB (active metal brazed) substrate or a leadframe. One example of a joining technique that is used to attach the die to the pad comprises sintering, wherein a fine particulate sinter material layer is arranged between the die and the pad and pressure and/or temperature is applied to fabricate a sintered metal layer out of the particulate sinter material layer.

Silver sintering requires a specific surface finish in order to be able to attach well to the parts to be joined. Ideally, the surfaces of both joining partners possess a noble metal finish such as silver or gold which does not form a stable oxide under ambient conditions (gold) or whose oxide decomposes below the sintering temperature (silver). That way - under sintering conditions - there is no oxide layer present on the joining partners which prevents the formation of a stable material-bonded interconnect. Such surface platings are readily available for DCB / AMB substrates, but do come at a significant cost.

For these and other reasons there is a need for the present disclosure.

### SUMMARY

Due to ever-increasing demands for higher operating temperatures of power modules, in particular in automotive applications, new packaging technologies are currently being introduced by virtually all power module manufacturers. One central technology is the so-called low-temperature joining technique (LTJT), which is commonly referred to as silver sintering. An example of silver sintering as a die attach technology is explained in the following. In short, a fine silver powder (which is usually provided in paste form) is placed between the two parts to be joined, these parts would be, for example, a die and a DCB (direct copper bond) or an AMB (active metal brazed) substrate. The whole assembly is then heated up to temperatures between 200 and 300°C, preferably but not necessarily under an externally applied pressure, e.g. in a press at a pressure in a range from 5 to 30 MPa and for a time duration in a range from 1 to 60 min. Under these conditions, the fine silver particles begin to sinter, i.e. they "grow together" or sinter to form a fairly compact silver layer by diffusional mechanisms. Since this layer consists of virtually pure silver (Ag) it possesses a melting point of 961°C which is much higher than that of soldered interconnects. This is one major factor why silversintered interconnects have superior properties compared to soldered ones when operated at elevated temperatures (T >= 175°C).

The above-described procedure can also be performed using fine particles made from metals other than Ag, for example, Cu or noble metal powders or mixtures thereof. The present disclosure is independent of the nature of the particulate metal that is used for fabricating the sintered interconnect. As a consequence, it will be continued here to use only the term silver sintering, but will imply that Cu or other sinter materials will benefit to the same extent.

While sintering on bare Cu is possible for attaching dies to DCB / AMB substrates, it does not represent an option when trying to further sinter these substrates to a metallic baseplate or a cooler. Such sintered substrate-to-baseplate / substrate-to-cooler interconnects are currently receiving significant attention throughout the entire industry for two major reasons:
1) Further improvement of power module performance by substituting an interconnect that is currently fabricated by less performant packaging technologies, such as soft soldering with a sintered one.
2) Realization of better system integration of molded halfbridge modules into more complex assembly groups, e.g. halfbridges sintered to a water-cooled cooler assembly which customers can directly mount into their inverters.

Unfortunately, baseplates and/or coolers are often not made from materials on which one can readily perform silver sintering. Two main reasons for this quickly come to mind:
1) Typical baseplates or cooler materials are often aluminum-based for reasons of weight, cost etc. It is intrinsic to aluminum that it forms an extremely stable oxide layer. This is why aluminum-based baseplates / coolers are nickel-coated when being processed by soldering. Unfortunately, sintering cannot be performed reliably on either aluminum or nickel which is why a noble metal surface finish would be used. Due to the sheer size of baseplates / coolers such noble metal coatings are extremely costly.
2) Copper baseplates / coolers are also sometimes used for their good thermal performance. These are usually also coated with nickel. Without the nickel coating, sintering on these baseplates / coolers is, in principle, possible with available technologies (albeit at increased process costs as described before). However, bare Cu parts have the drawback of being prone to staining when being exposed to atmosphere and / or contaminants such as fingerprints. This is not acceptable for parts which are later visible to the customer.

As a result, none of the existing baseplate / cooler solutions can be used for sintered substrate-to-baseplate / substrate-to-cooler interconnects. One solution would be to apply a noble metal finish (silver or gold) to the baseplates / coolers, but a gold plating would be extremely expensive due to the sheer size of the components. A completely silvercoated baseplate / cooler has issues which are similar issues to those of bare Cu components because it tends to stain when being exposed for prolonged times under ambient atmosphere, in particular, if sulfur is present.

The present disclosure addresses these issues in a targeted way. A method will be provided by which conventionally used baseplates / coolers can be selectively coated with noble metal layers on which silver sintering is feasible at high quality.

A first aspect of the present disclosure is related to a method comprising providing a substrate, applying a metal powder layer onto the substrate, melting and re-solidifying a predetermined area of the metal powder layer by scanning a laser beam or an electron beam over the predetermined area, and removing the remaining area of the metallic powder layer outside the predetermined area.

According to an embodiment of the method of the first aspect, the substrate is one or more of an Al baseplate, an Al leadframe, an Al cooler, a Ni plated baseplate, a Ni plated leadframe, or a Ni plated cooler.

According to an embodiment of the method of the first aspect, the metal powder of the metal powder layer comprises Ag, Au, Cu, Pd, any other noble metal, or mixtures thereof.

According to an embodiment of the method of the first aspect, applying the metal powder layer is done by providing a layer of homogeneous thickness across the substrate to be coated, e.g. by spreading, in particular with a squeegee, printing, screen printing, or dispensing.

According to an embodiment of the method of the first aspect, a thickness of the metal powder layer is in a range from 1 µm to 10 pm, or 10 µm to 100 pm, or >100 µm.

According to an embodiment of the method of the first aspect, melting and re-solidifying is performed under an inert gas atmosphere.

According to an embodiment of the method of the first aspect, the inert gas atmosphere comprises one or more of an N2 atmosphere, a reducing gas atmosphere, a N2/H2 atmosphere, a noble gas atmosphere, e.g. Ar, or an Ar/H2 atmosphere.

A second aspect of the present disclosure is related to a method for fabricating an electrical device, the method comprising providing a substrate, applying a metal powder layer onto the substrate, melting and re-solidifying a predetermined area of the metal powder layer by scanning a laser or electron beam over the predetermined area, and removing the remaining area of the metallic powder layer outside the predetermined area, depositing a particulate sinter material layer onto the predetermined area, applying an electrical component on the particulate sinter material layer, and performing a sintering process to convert the particulate sinter material layer to a sintered layer.

According to an embodiment of the method of the second aspect, the electrical component is one or more of a semiconductor die, a semiconductor transistor die, a semiconductor power transistor die, or a semiconductor diode die.

Further embodiments of the method of the second aspect can be formed together with any features or embodiments described in connection with the method of the first aspect throughout the present disclosure.

A third aspect of the present disclosure is related to an electrical device, comprising a substrate, a metallic layer disposed on the substrate, the metallic layer being fabricated by melting and re-solidifying a metallic powder layer, a sintered layer disposed on the metallic layer, and an electrical component disposed on the sintered layer.

According to an embodiment of the electrical device of the third aspect, the substrate is one or more of an Al baseplate, an Al leadframe, an Al cooler, a Ni plated baseplate, a Ni plated leadframe, or a Ni plated cooler.

According to an embodiment of the electrical device of the third aspect, the metallic layer comprises Ag, Au, Cu, Pd, any other noble metal, or mixtures thereof.

According to an embodiment of the electrical device of the third aspect, a thickness of the metallic layer is in a range from 1 µm to 10 pm, or from 10 µm to 100 pm, or > 100 µm.

According to an embodiment of the electrical device of the third aspect, the sintered layer comprises silver, copper, gold, palladium, nickel, or mixtures thereof.

According to an embodiment of the electrical device of the third aspect, the electrical component is one or more of a semiconductor die, a semiconductor transistor die, a semiconductor power transistor die, or a semiconductor diode die.

Further embodiments of the electrical device of the third aspect can be formed together with any features or embodiments or features described in connection with the methods of the first and second aspect throughout the present disclosure.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 comprises Fig. 1(a) to 1(e) and shows perspective views for illustrating an example of a method for fabricating a sinterable metallic layer according to the first aspect.
Fig. 2 shows a cross-sectional side view on an example of an electrical device according to the third aspect.
Fig. 3 shows a perspective view on a further example of an electrical device according to the third aspect.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

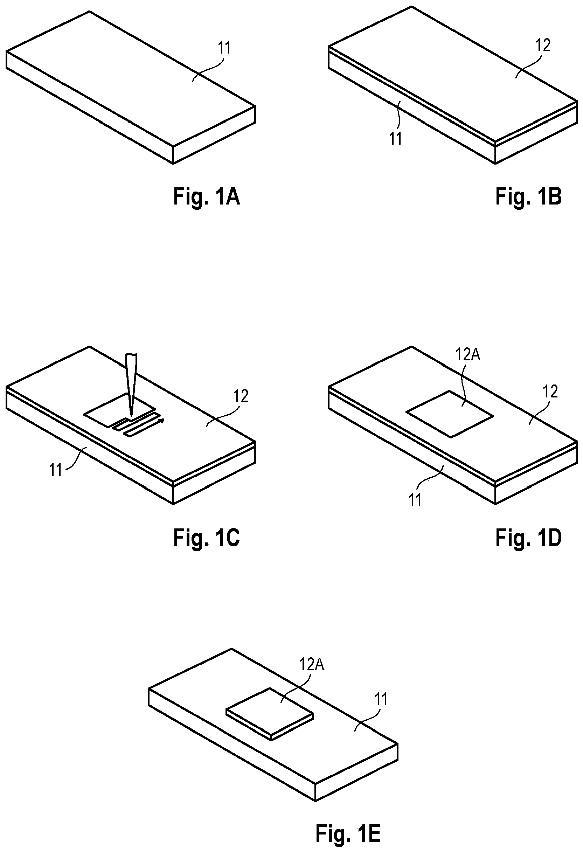

Fig. 1 comprises Fig. 1(a) to 1(e) and shows perspective views for illustrating an example of a method for fabricating a sinterable metallic layer according to the first aspect.

Fig. 1(a) shows a substrate 11 on which a sinterable metallic layer is to be provided. The substrate 11 may have the cuboid shape shown, but may otherwise comprise any other shape. Otherwise, the substrate 11 may generally comprise a material on which a sintered layer can either not be produced at all or only under difficult circumstances. In particular, the substrate 11 may be one or more of an Al baseplate, an Al leadframe, an Al cooler, a Ni plated baseplate, a Ni plated leadframe, or a Ni plated cooler.

Fig. 1(b) shows an intermediate product obtained after applying a metal powder layer 12 onto the substrate. The metal powder of the metal powder layer 12 may comprise Ag, Au, Cu, Pd, any other noble metal, or mixtures thereof. Applying the metal powder layer 12 can be done by one or more of printing, screen printing, dispensing, or applying the powder with a squeegee. A thickness of the metal powder layer can be in a range from 1 µm to 10 µm.

Fig. 1(c) shows an intermediate product obtained after melting and re-solidifying a predetermined area of the metal powder layer by scanning a laser beam or an electron beam over the predetermined area. The predetermined area may, for example, be an approximately square or rectangular area as shown. In the case of using a laser beam the laser beam can be focused on the surface of the metal powder layer by means of a lens and scanned over the surface in such a way that the metal particles of the metal powder layer are fused together. The wavelength of the laser beam can be in the infrared range, for example.

Fig. 1(d) shows an intermediate product obtained after solidifying of the previously molten area of the metal powder layer 12. The re-solidification takes place automatically after the laser beam has left a previously irradiated area. After re-solidification a coherent metallic layer 12A is formed.

Fig. 1(e) shows an intermediate product obtained after removing the remaining area of the metallic powder layer 12 outside the predetermined are so that only the metallic layer 12A is left back.

Thereafter in order to fabricate an electrical device according to a method of the second aspect, a particulate sinter material layer can be deposited onto the metallic layer 12A, an electrical component can be applied on the particulate sinter material layer, and a sintering process can be performed to convert the particulate sinter material layer to a sintered layer. The particulate sinter material layer may comprise a sinter paste layer. Such an electrical device will be shown in the next Figure.

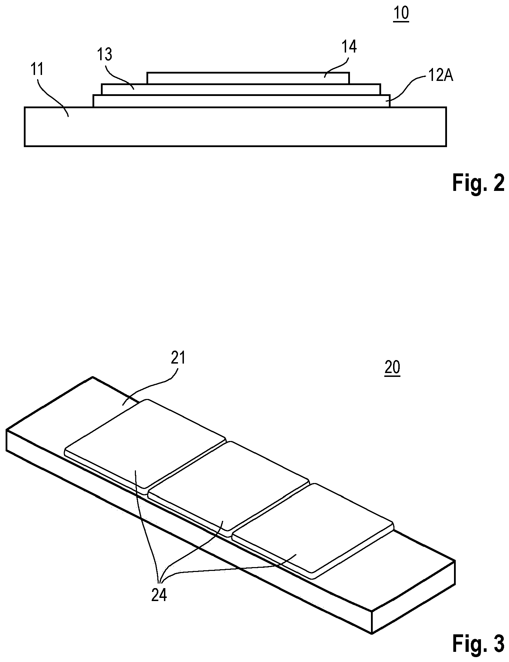

Fig. 2 shows a cross-sectional side view on an example of an electrical device according to the third aspect.

More specifically, the electrical device 10 of Fig. 2 shows a substrate 11, a metallic layer 12A disposed on the substrate 11, a sintered layer 13 disposed on the metallic layer 12A, and an electrical component 14 disposed on the sintered layer 13.

The metallic layer 12A is fabricated by melting and re-solidifying a metallic powder layer 12 as was explained before in connection with Fig. 1.

The particulate sinter material layer applied onto the metallic layer 12A may comprise silver particles embedded in a paste. In the subsequent sintering process the silver particles are baked together under the action of temperature and, if necessary, pressure to form a continuous electrically conductive sintered layer 13.

The electrical component 14 can be one or more of a semiconductor die, a semiconductor transistor die, a vertical semiconductor transistor die, a semiconductor power transistor die, an IGBT die, a MOSFET die, or a semiconductor diode die. A vertical semiconductor transistor die would comprise a drain contact pad on a backside and a stack of metallization layer applied on the drain pad. The lowermost layer of this stack would be in direct contact with the sintered layer 13.

Fig. 3 shows a perspective view on a further example of an electrical device according to the third aspect.

More specifically, the electrical device 20 of Fig. 3 shows a substrate 21, a metallic layer 22A (not shown) disposed on the substrate 21, a sintered layer 23 (not shown) disposed on the metallic layer 12A, and electrical components 24 disposed on the sintered layer 23.

In this case the substrate 21 is formed by an Al cooler 21 and the electrical components 14 are formed by half-bridge circuits 14. Each of the half-bridge circuits 24 has two semiconductor transistors in a known manner, one of which assumes the role of the high-side switch and the other the role of the low-side switch. Since both semiconductor transistors are designed as high-power transistors, cooling is necessary to dissipate the excessive heat resulting from the switching operations. This cooling is provided by the Al cooler, which has a cavity through which a cooling medium is passed.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method for fabricating a sinterable metal layer, the method comprising:
- providing a substrate;
- applying a metal powder layer onto the substrate;
- melting and re-solidifying a predetermined area of the metal powder layer by scanning a laser beam or an electron beam over the predetermined area; and
- removing the remaining area of the metallic powder layer outside the predetermined area.

2. The method according to claim 1, wherein
the substrate is one or more of an Al baseplate, an Al leadframe, an Al cooler, a Ni plated baseplate, a Ni plated leadframe, or a Ni plated cooler.

3. The method according to claim 1 or 2, wherein
the metal powder of the metal powder layer comprises Ag, Au, Cu, Pd, any other noble metal, or mixtures thereof.

4. The method according to any one of the preceding claims, wherein
applying the metal powder layer is done by one or more of printing, screen printing, dispensing, or applying with a squeegee.

5. The method according to any one of the preceding claims, wherein
a thickness of the metal powder layer is in a range from 1 µm to 10 pm, or from 10 µm to 100 pm, or > 100 µm.

6. The method according to any one of the preceding claims, wherein
melting and re-solidifying is performed under an inert gas atmosphere.

7. The method according to any one of claim 6, wherein
the inert gas atmosphere comprises one or more of an N2 atmosphere, a reducing gas atmosphere, a noble gas atmosphere, e.g. Ar, a N2/H2 atmosphere, or an Ar/H2 atmosphere.

8. A method for fabricating an electrical device, the method comprising
- providing a substrate;
- applying a metal powder layer onto the substrate;
- melting and re-solidifying a predetermined area of the metal powder layer by scanning a laser beam over the predetermined area; and
- removing the remaining area of the metallic powder layer outside the predetermined area;
- depositing a particulate sinter material layer onto the predetermined area;
- applying an electrical component on the particulate sinter material layer, and
- performing a sintering process to convert the particulate sinter material layer to a sintered layer.

9. The method according to claim 8, wherein
the particulate sinter material layer comprises a sinter paste layer.

10. The method according to claim 8 or 9, wherein
the electrical component is one or more of a semiconductor die, a semiconductor transistor die, a semiconductor power transistor die, or a semiconductor diode die.

11. An electrical device (10; 20), comprising
- a substrate (11; 21);
- a metallic layer (12A) disposed on the substrate (11; 21), the metallic layer (12A) being fabricated by melting and re-solidifying a metallic powder layer (12);
- a sintered layer (13) disposed on the metallic layer (12A); and
- an electrical component (14; 24) disposed on the sintered layer.

12. The electrical device (10; 20) according to claim 11, wherein
the substrate (11; 21) is one or more of an Al baseplate, an Al leadframe, an Al cooler, a Ni plated baseplate, a Ni plated leadframe, or a Ni plated cooler.

13. The electrical device (10; 20) according to claim 11 or 12, wherein
the metallic layer (12A) comprises Ag, Au, Cu, Pd, any other noble metal, or mixtures thereof.

14. The electrical device (10; 20) according to any one of claims 11 to 13, wherein
a thickness of the metallic layer (12A) is in a range from 1 µm to 10 µm.

15. The electrical device (10; 20) according to any one of claims 11 to 14, wherein
the sintered layer (13) comprises nickel, silver or gold.

16. The electrical device (10; 20) according to any one of claims 11 to 15, wherein
the electrical component (14; 24) is one or more of a semiconductor die, a semiconductor transistor die, a semiconductor power transistor die, or a semiconductor diode die.
